# FASCICULE DE BREVET EUROPEEN

(11) **EP 0 695 035 B1**
(45) Date de publication et mention de la délivrance du brevet: **23.06.1999**
(21) Numéro de dépôt: 95401706.7
(22) Date de dépôt: 18.07.1995
(51) Int. Cl.: H03K 5/24, H03M 1/34

(54) **Comparateur et convertisseur A/N à comparaison multiple utilisant le principe d'interpolation**
Komparator und Mehrfachvergleichs-A/D-Wandler unter Anwendung des Interpolationsprinzips
Comparator and multiple comparison A/D-converter using the interpolation principle

(30) Priorité: 18.07.1994 FR 9408958
(43) Date de publication de la demande: 31.01.1996
(73) Titulaire: THOMSON multimedia, 92648 Boulogne Cédex (FR)
(72) Inventeur: Dell'Ova, Francis, La Défense 5, F-92400 Courbevoie (FR); Paillardet, Frédéric, La Défense 5, F-92400 Courbevoie (FR)
(74) Mandataire: Ruellan-Lemonnier, Brigitte

(56) Documents cités:
- EP-A- 0 404 476
- EP-A- 0 591 868
- US-A- 5 302 869
- PROCEEDINGS OF THE IEEE 1992 INTEGRATED CIRCUITS CONFERENCE, Mai 1992 NEW YORK, US, pages 16.8.1-16.8.4, K. J. MCCALL ET AL. 'A 6-bit 125 MHz CMOS A/D Converter'
- L.A.GLASSER and D.W.DOBBERPUHL: "The design and analysis of VLSI circuits", 1985, Addison-Wesley Publishing Company, Reading, Massachusetts, US; page 79

## Description

La présente invention concerne un comparateur de tensions dit à "auto-zéro", ainsi qu'un convertisseur analogique-numérique (A/N) utilisant un ensemble de comparateurs dits à "auto-zéro" permettant de réduire le nombre de comparateurs nécessaires à la conversion A/N.

Le document "A 6 bits 125 MHz CMOS A/D Converter" de Kevin J.McCall (IEEE 1992 Custom Integrated Circuits Conférence, 16.8.1) décrit un convertisseur A/N de type flash. Un perfectionnement à ce type de convertisseur flash est l'application du principe d'interpolation, illustré par la figure 1 et notamment décrit dans le document EP-A-0 591 868. Par rapport à un convertisseur flash classique constitué d'un certain nombre de comparateurs, ce perfectionnement consiste à supprimer par couplage capacitif la moitié d'un comparateur sur deux et ainsi de gagner en place et en consommation.

Pour plus de clarté, on va se limiter dans l'explicatif qui suit à un nombre restreint de tensions de référence Vrefi, Vrefj, Vrefk et Vrefl, mais ces explications peuvent évidemment être étendues à un convertisseur à n entrées. D'autre part, les éléments des figures ayant les mêmes fonctions ont gardé les mêmes références dans les différentes figures.

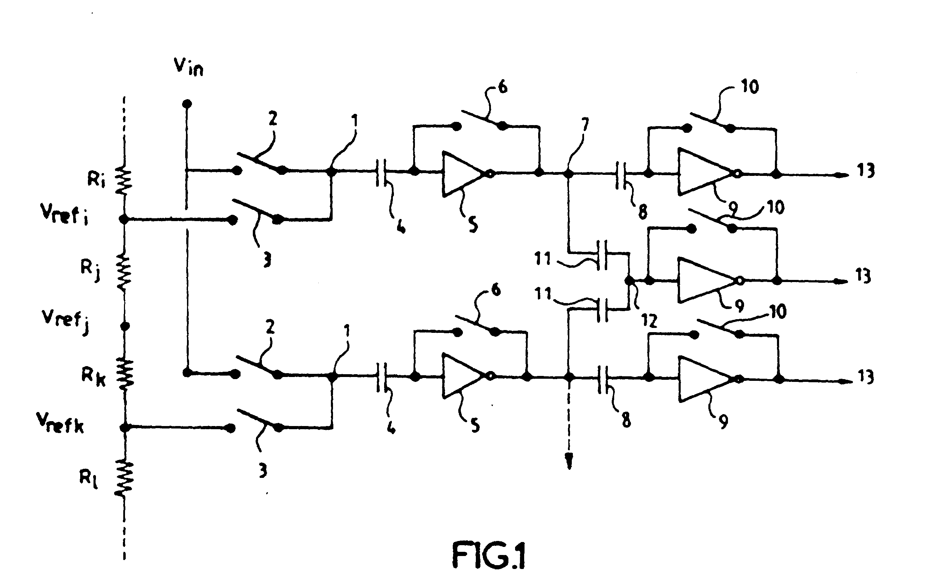

Sur la figure 1, la ligne de résistances série Ri, Rj, Rk, etc ... fournit les tensions de références Vrefi, Vrefj, Vrefk, etc ... qui sont respectivement celles des noeuds i, j, k I etc .... Ces tensions de référence ne sont prises en compte qu'une fois sur deux. C'est-à-dire que dans une série Vrefi, Vrefj, Vrefk et Vrefl, seules seront connectées directement aux circuits comparateurs les tensions Vrefi et Vrefk. Sur la figure 1, les tensions de référence Vrefi et Vrefk sont connectées au noeud 1 via les interrupteurs 3, la tension Vin étant connectée à ce même noeud 1 par les interrupteurs 2. Sont ensuite connectées en série aux noeuds 1, les capacités 4, les inverseurs 5 dont les bornes sont reliées par un interrupteur 6, et les noeuds 7. Viennent ensuite, et toujours en série, les capacités 8 connectées en série aux inverseurs 9 dont les bornes sont reliées par les interrupteurs 10, et enfin les sorties 13.

Ce type de comparateur, appelé à auto-zéro, permet de polariser temporairement les inverseurs dans leurs zones de gain (proche de Vdd/2). Cette fonction d'auto-zéro est obtenue en fermant les interrupteurs 6 et 10 (par séquencement interne) des dispositifs inverseurs 5 et 9. Le fait d'avoir deux dispositifs à auto-zéro en série par comparateur permet d'obtenir une pente de gain plus forte, et ainsi de réaliser des comparaisons plus fines puisque l'inverseur est dans une situation instable et est très sensible à la différence Vref - Vin. Dans un séquencement habituel, les interrupteurs 6 et 10 des dispositifs auto-zéro sont ouverts et fermés simultanément, ceci étant justifié par les performances dynamiques que l'on souhaite obtenir.

Le perfectionnement par rapport à un convertisseur flash classique consiste à remplacer le comparateur j par un demi-comparateur j constitué de deux capacités 11 en série reliant les noeuds 7 des comparateurs adjacents et dont la valeur C/2 est la moitié de la valeur C des capacités 8. Au noeud 12 entre ces deux capacités 11, un dispositif à auto-zéro du même type que ceux des comparateurs adjacents est connecté à la sortie 13 par l'intermédiaire d'un inverseur 9 dont les bornes sont reliées par un interrupteur 10. Le pont diviseur capacitif formé par les capacités 11 de valeurs C/2 donne la valeur de la tension à comparer pour le comparateur médian (demi-comparateur j). Dans ce dispositif, le facteur d'interpolation est de 2, mais peut être accru à 4 ou 8. En réduisant le nombre d'étages, on réduit la consommation et la surface.

L'inconvénient majeur de cette structure réside dans le fait que l'on surchage l'étage de gain précédent et donc que l'on diminue sensiblement la fréquence maximum d'utilisation pour une consommation donnée. Ceci a pour effet immédiat de limiter les performances temporelles du dispositif. En effet, les capacités parasites associées aux capacités "utiles" sont loin d'être négligeables, elles sont typiquement de l'ordre de 0,8xC.

Le document EP-A- 0 404 476 concerne quant à lui un comparateur à auto-zéro pour un convertisseur analogique/numérique dans lequel le second étage comporte deux transistors montés en inverseurs et un interrupteur connectant le drain et la grille de l'un des transistors pour réaliser la fonction auto-zéro.

La présente invention a pour but de s'affranchir des inconvénients mentionnés plus haut en utilisant un principe qui n'est pas lié à un ratio de capacité pour réaliser l'interpolation.

A cet effet, la présente invention concerne un comparateur interpolé à comparaisons multiples, comportant :
- un premier et un troisième comparateur à auto-zéro comprenant chacun un premier et un second étage, ainsi qu'intercalé entre le premier et le troisième comparateur, un second comparateur comportant seulement un second étage connecté aux deux sorties des deux premiers étages des comparateurs adjacents,
- le premier étage de chacun des premier et troisième comparateurs comportant une capacité destinée à être chargée par les tensions à comparer respectivement via deux premiers interrupteurs, et un inverseur dont les bornes d'entrée et de sortie sont reliées par un second interrupteur en vue de réaliser la fonction auto-zéro,
- le second étage de chacun des premier et troisième comparateurs comportant un premier transistor dont la grille est commandée par la sortie de l'étage précédent, ledit premier transistor étant monté en inverseur avec un second transistor, dont la grille et le drain sont reliés par un premier interrupteur en vue de réaliser la fonction auto-zéro, et un troisième transistor utilisé en tant que capacité et dont la grille est connectée à la grille du second transistor, et dont la source et le drain sont connectés à une tension d'alimentation,
- le second étage du second comparateur comportant deux premiers transistors en parallèle dont les grilles sont commandées respectivement par les sorties des premiers étages des comparateurs adjacents, les deux premiers transistors formant un inverseur avec deux seconds transistors en paralllèle dont les grilles sont connectées en commun et sont connectées à travers un premier interrupteur aux drains des deux premiers transistors en vue de réaliser la fonction auto-zéro, ledit second étage comprenant en outre deux troisièmes transistors dont les sources et drains sont reliés à la tension d'alimentation et les grilles connectées aux grilles des seconds transistors.

Des modes de réalisations particuliers de l'invention sont indiqués dans les revendications 2, 3 et 4.

Selon un mode de réalisation de la présente invention, un second interrupteur est ajouté au second étage du comparateur connectant les grilles des second et troisième transistors à la tension d'alimentation.

L'invention concerne également un convertisseur A/N comportant un ou plusieurs comparateurs interpolés à comparaisons multiples décrits ci-dessus.

Selon un aspect de l'invention, les interrupteurs du ou desdits comparateurs interpolés à comparaisons multiples sont commandés selon le séquencement suivant :
- fermeture du second interrupteur du premier étage et du second interrupteur du second étage, le premier interrupteur du second étage étant ouvert ;
- fermeture rapide du premier interrupteur du second étage et ouverture simultanée du second interrupteur du second étage ;
- ouverture du second interrupteur du premier étage et du premier interrupteur du second étage juste avant la phase de comparaison.

Gâce à ce séquencement non simultané des dispositifs auto-zéro, la consommation du comparateur est réduite sans pour autant diminuer les performances dynamiques du comparateur.

La présente inventions s'applique de préférence à un convertisseur A/N CMOS à comparaisons multiples utilisant au moins un comparateur dit à "auto-zéro".

La présente invention sera mieux comprise et les avantages supplémentaires apparaîtront à la lecture de la description qui va suivre, illustrée par les figures suivantes :
- la figure 1 déjà décrite représente une partie d'un comparateur à multiples entrées utilisé dans un convertisseur connu ;
- la figure 2a représente une partie d'un comparateur selon un premier mode de réalisation de l'invention ;
- la figure 2b représente un convertisseur A/N CMOS selon ce premier mode de réalisation de l'invention ;
- la figure 3a représente une partie d'un comparateur selon un second mode de réalisation de l'invention, et
- la figure 3b représente le séquencement des interrupteurs du comparateur de la figure 3a.

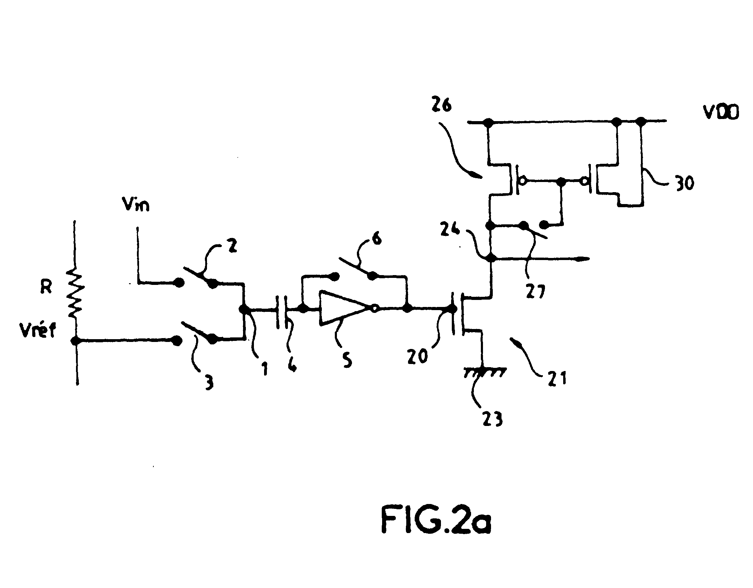

Le comparateur selon l'invention de la figure 2a comporte un premier étage équivalent à celui des comparateurs connus tels que décrits dans la figure 1, aussi les références désignant les mêmes caractéristiques sont conservées d'une figure à l'autre. Les tensions Vin et Vref à comparer sont toutes deux reliées aux noeuds 1 au travers des interrupteurs 2 et 3 connectés en série à une capacité 4, un inverseur 5 dont les bornes sont reliées par un interrupteur **6** réalisant la fonction auto-zéro. Une caractéristique importante de la présente invention est que ce premier étage commande la grille **20** d'un premier transistor **21** de préférence nMOS, la source étant connectée en **23** à la masse et le drain à un noeud **24**. Ce noeud **24** est connecté à la fois au drain d'un second transistor **26**, et à la grille de ce même transistor **26**, de préférence pMOS, via un interrupteur **27**. La grille du transistor **26** est connectée à la grille d'un troisième transistor **30**. La source du second transistor **26** ainsi que les sources et drains du troisième transistor **30**, qui se comporte comme une capacité, sont connectés à la tension Vdd. La sortie de ce comparateur s'effectue à partir du noeud **24**.

Dans ce deuxième étage du comparateur, les transistors MOS n **21** et p **26** forment aussi un étage inverseur, la fonction auto-zéro étant réalisée en fermant l'interrupteur **27** qui connecte la grille et le drain du transistor **26**. Pendant la même phase, une capacité de faible valeur **C 30** est chargée à la tension d'auto-zéro, c'est à dire à la polarisation d'équilibre de l'inverseur constitué par les transistors **21** et **26**, qui sera maintenue jusqu'au moment de la comparaison. Pendant la phase de comparaison, les interrupteurs **6** et **27** sont évidemment ouverts, et les transistors MOS **21** et **26** se comportent simplement comme un étage de gain. Les avantages de ce type d'étages sont que la valeur C de la capacité **30** peut être très faible (de l'ordre de celle de la grille d'un MOS) et donc la vitesse de réponse très grande, la précision relative entre comparateur de cette capacité n'est pas critique, et enfin, la charge ramenée sur le premier étage est cinq à dix fois moins importante que dans la structure classique décrite dans la figure **1**.

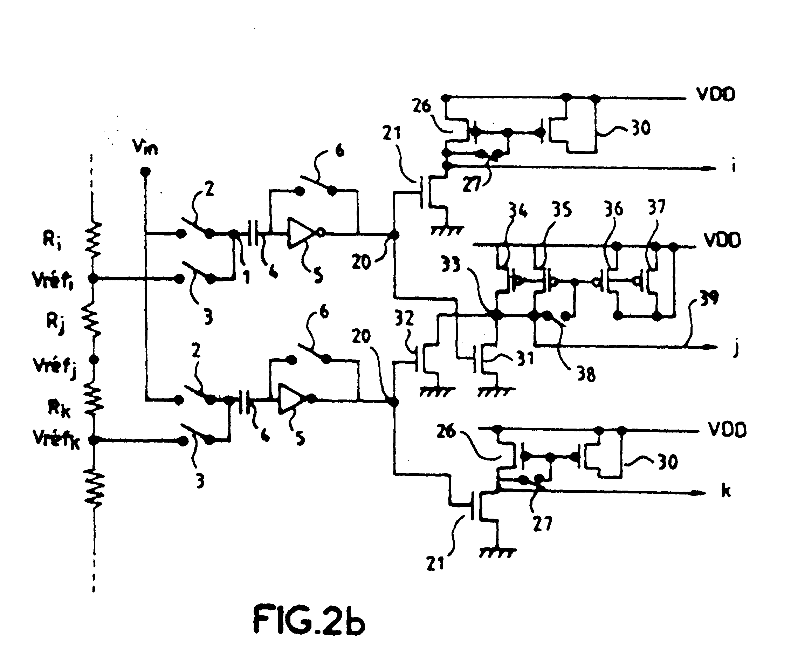

La figure **2b** représente l'application de ce comparateur à un comparateur multiple selon le premier mode de réalisation de l'invention, par exemple à n étages. L'adaptation du dispositif de la figure **2a** à un système interpolé consiste à dupliquer le deuxième étage du comparateur de la figure **2**.

Sur la figure **2b** on retrouve les comparateurs i et k tels qu'is ont été décrits à partir de la figure **2a**, mais en revanche, le comparateur médian j est dupliqué par rapport à celui de la figure **2a**. En effet, les noeuds **20** des comparateurs adjacents i et k commandent respectivement les premiers transistors **31** et **32** dont les sources sont reliées à la masse, ceux-ci formant la première partie de l'inverseur du comparateur médian j. Les drains de ces premiers transistors sont reliés au noeud **33**. Des seconds transistors **34** et **35** dupliqués par rapport à ceux des étages adjacents i et j, sont connectés en parallèle d'un côté à ce noeud **33** et de l'autre à la tension d'alimentation Vdd, et réalisent la seconde moitié de l'inverseur du comparateur médian j.

Des troisièmes transistors **36** et **37** dupliqués eux aussi par rapport au montage équivalent des étages adjacents, ont leurs sources et drains connectés à la tension d'alimentation Vdd, et réalisent la capacité chargée à la polarisation d'équilibre de l'inverseur du comparateur médian j.

Un interrupteur **38** connecte le noeud **33** aux grilles des transistors **34**, **35 36** et **37**.

Enfin, la sortie du comparateur j vers un étage intermédiaire est faite à partir du noeud **33**.

Le moyennage des valeurs supérieures et inférieures des étages adjacents est dans ce cas de type gain au lieu d'être de type capacitif comme dans l'art antérieur, par la commande de grille des transistors MOS **31** et **32**.

Le principal avantage de cette solution est de ramener sur la sortie des premiers étages une charge minimum et donc d'accroître la vitesse de fonctionnement. De plus, elle réduit l'encombrement car la solution de l'art antérieur (capacité) est comparativement plus grande.

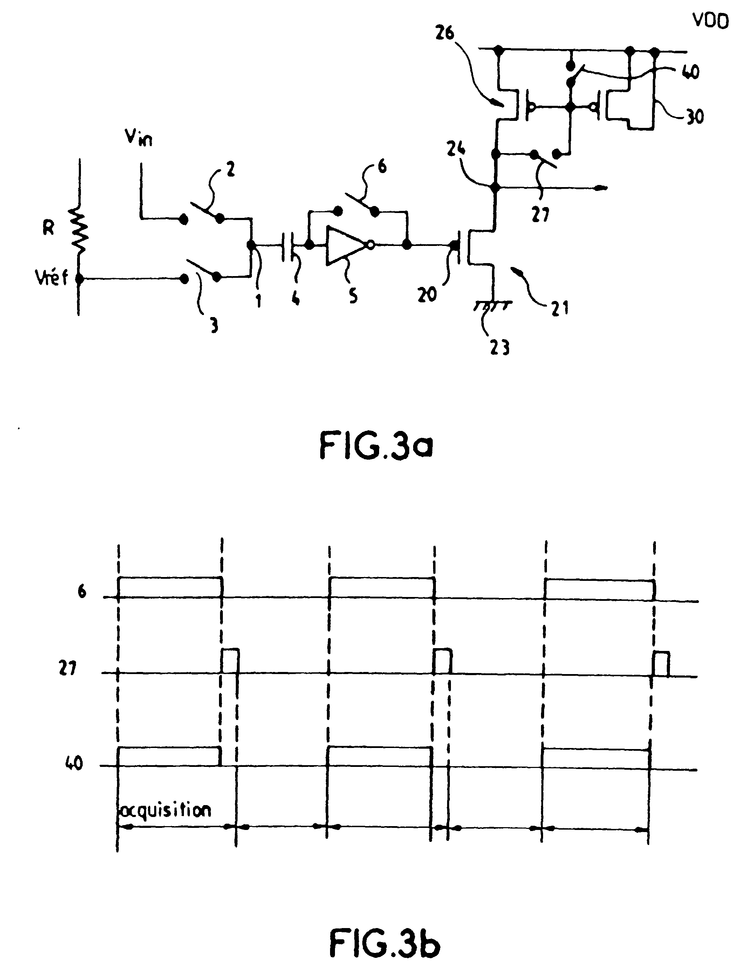

La figure **3a** représente une partie d'un second mode de réalisation de l'invention qui permet de réduire encore la consommation d'un comparateur sans diminuer les performances dynamiques. La structure de ce comparateur selon un second mode de réalisation de l'invention est presque identique à celle du premier mode de réalisation de l'invention de la figure **2a**, avec un interrupteur **40** joignant les grilles des transistors **26** et **30** à la tension d'alimentation Vdd. On a vu précédemment à partir de la figure **2a** que la fonction auto-zéro du second étage est réalisée en fermant l'interrupteur **27**. Cet auto-zéro est très rapide car la capacité **C 30** devant mémoriser la tension sur la grille du transistor **26** peut être d'une faible valeur. Ce système a pour avantage de rester toujours bien polarisé par le transistor **26** même lorsque l'on s'écarte de la polarisation d'équilibre de l'auto-zéro (vitesse de réaction).

Par rapport au mode de réalisation de la figure **2a**, le second mode de réalisation met en oeuvre le séquencement suivant illustré par la figure **3b**: pendant la phase d'auto-zéro du premier étage (phase d'acquisition), l'interrupteur **6** est fermé, le **27** ouvert et le **40** fermé afin de couper la consommation du second étage. Juste avant la comparaison, l'interrupteur **40** est ouvert et le **27** fermé simultanément et rapidement afin de réaliser la fonction d'auto-zéro du second étage. Juste avant la phase de comparaison, les interrupteurs **6** et **27** sont ouverts.

Pour la phase de comparaison fine dans un convertisseur demi-flash, ceci permet de couper la consommation du second étage une période sur deux.

Ce type de comparateur peut être utilisé dans un convertisseur A/N interpolé à comparaison multiples de la même manière que le premier mode de réalisation de l'invention de la figure **2b**, il suffit d'ajouter à la structure de cette figure **2b** des interrupteurs **40** joignant les grilles des transistors **26** et **30** à la tension d'alimentation, et dans les étages médians, d'ajouter un interrupteur joignant les grilles des transistors **34**, **35**, **36** et **37**, à cette même source d'alimentation.

L'ensemble des transistors et interrupteurs cités dans la description de l'invention à partir des figures **2a**, **2b**, **3a** et **3b** sont de préférence des transistors MOS.

La présente invention s'applique en particulier à tous les types de convertisseurs A/N CMOS à comparaisons multiples utilisant au moins un comparateur dit à "auto-zéro".

## Revendications

1. Comparateur interpolé à comparaisons multiples, comportant :
- un premier et un troisième comparateur (i,k) à auto-zéro comprenant chacun un premier et un second étage, ainsi qu'intercalé entre le premier et le troisième comparateur, un second comparateur (j) comportant seulement un second étage connecté aux deux sorties des deux premiers étages des comparateurs adjacents (i,k),
- le premier étage de chacun des premier et troisième comparateurs (i,k) comportant une capacité (4) destinée à être chargée par les tensions à comparer (Vrefi, Vrefk, Vin) respectivement via deux premiers interrupteurs (2, 3), et un inverseur (5) dont les bornes d'entrée et de sortie sont reliées par un second interrupteur (6) en vue de réaliser la fonction auto-zéro,
- le second étage de chacun des premier et troisième comparateurs (i,k) comportant un premier transistor (21) dont la grille est commandée par la sortie de l'étage précédent, ledit premier transistor étant monté en inverseur avec un second transistor (26), dont la grille et le drain sont reliés par un premier interrupteur (27) en vue de réaliser la fonction auto-zéro, et un troisième transistor (30) utilisé en tant que capacité et dont la grille est connectée à la grille du second transistor (26), et dont la source et le drain sont connectés à une tension d'alimentation (Vdd),
- le second étage du second comparateur (j) comportant deux premiers transistors (31,32) en parallèle dont les grilles sont commandées respectivement par les sorties (20) des premiers étages des comparateurs adjacents (i, k), les deux premiers transistors formant un inverseur avec deux seconds transistors (34, 35) en parallèle dont les grilles sont connectées en commun et sont connectées à travers un premier interrupteur (38) aux drains des deux premiers transistors en vue de réaliser la fonction auto-zéro, ledit second étage comprenant en outre deux troisièmes transistors (36, 37) dont les sources et drains sont reliés à la tension d'alimentation (Vdd) et les grilles connectées aux grilles des seconds transistors (34, 35).

2. Comparateur selon la revendication 1, caractérisé en ce qu'il comporte un second interrupteur pour couper la consommation du second étage du second comparateur (j) pendant la phase d'auto-zéro des premiers étages, ledit second interrupteur étant connecté entre la tension d'alimentation (Vdd) et les grilles des seconds et troisièmes transistors (34, 35, 36, 37).

3. Comparateur selon l'une des revendications 1 ou 2, caractérisé en ce qu'il comporte un second interrupteur pour couper la consommation du second étage du premier ou du troisième comparateur (i, k) pendant la phase d'auto-zéro des premiers étages, ledit second interrupteur étant connecté entre la tension d'alimentation (Vdd) et la grille des second et troisième transistors (26, 30).

4. Comparateur selon l'une des revendications précédentes, caractérisé en ce que les transistors et les interrupteurs sont des transistors MOS.

5. Convertisseur analogique/numérique caractérisé en qu'il comporte un ou plusieurs comparateurs interpolés à comparaisons multiples selon l'une quelconque des revendications 1 à 4.

6. Convertisseur analogique/numérique selon la revendication 5, caractérisé en ce que les interrupteurs du ou desdits comparateurs interpolés à comparaisons multiples sont commandés selon le séquencement suivant :
- fermeture du second interrupteur (6) du premier étage et du second interrupteur du second étage, le premier interrupteur (27, 38) du second étage étant ouvert,
- fermeture rapide du premier interrupteur (27, 38) du second étage et ouverture simultanée du second interrupteur du second étage,
- ouverture du second interrupteur (6) du premier étage et du premier interrupteur (27, 38) du second étage juste avant la phase de comparaison.

## Patentansprüche

1. Komparator mit Interpolation zum Mehrfachvergleich enthaltend:
- einen ersten und einen dritten Komparator (i, k) mit auto-zéro je mit einer ersten und einer zweiten Stufe, eingefügt zwischen dem ersten und dem dritten Komparator, einen zweiten Komparator (j) mit nur einer zweiten Stufe, die mit den beiden Ausgängen der beiden ersten Stufen der benachbarten Komparatoren (i, k) verbunden ist,
- wobei die erste Stufe des ersten und des dritten Komparators (i, k) eine Kapazität (4) enthalten, die jeweils über zwei erste Schalter (2, 3) durch die zu vergleichenden Spannungen (V_{refi},V_{refk},Vᵢₙ) aufgeladen wird, wobei ein Inverter (5) vorgesehen ist, dessen Eingangs- und Ausgangsanschlüsse zur Realisierung der auto-zéro-Funktion über einen zweiten Schalter (6) miteinander verbunden sind,
- wobei die zweite Stufe des ersten und des dritten Komparators (i, k) einen ersten Transistor (21) enthält, dessen Gate durch den Ausgang der vorangehenden Stufe gesteuert wird, wobei der erste Transistor mit einem zweiten Transistor (26) als Inverter geschaltet ist und das Gate und der Drain dieses Transistors (26) über einen ersten Schalter (27) für die Realisierung der auto-zéro-Funktion miteinander verbunden sind, und einen dritten Transistor (30) enthält, der als Kapazität dient und dessen Gate mit dem Gate des zweiten Transistors (26) verbunden ist und dessen Source und Drain an eine Betriebsspannung (VDD) angeschlossen sind,
- wobei die zweite Stufe des zweiten Komparators (j) zwei parallel geschaltete erste Transistoren (31, 32) enthält, deren Gates jeweils durch die Ausgänge (20) der ersten Stufen der benachbarten Komparatoren (i, k) gesteuert werden und die beiden ersten Transistoren mit den beiden parallel geschalteten zweiten Transistoren (34, 35) einen Inverter bilden, deren Gates miteinander verbunden und über einen ersten Schalter (38) mit den Drains der beiden ersten Transistoren verbunden sind, um die auto-zéro-Funktion zu bilden, und die zweite Stufe außerdem zwei dritte Transistoren (36, 37) enthält, deren Sourcen und Drains mit der Betriebsspannung (VDD) und deren Gates mit den Gates der zweiten Transistoren (34, 35) verbunden sind.

2. Komparator nach Anspruch 1, dadurch gekennzeichnet, daß der Komparator einen zweiten Schalter zur Unterbrechung der Stromversorgung der zweiten Stufe des zweiten Komparators (j) während der Phase des auto-zéro der ersten Stufen enthält, und daß der zweite Schalter zwischen der Betriebsspannung (VDD) und den Gates des zweiten und der dritten Transistoren (34, 35, 36, 37) liegt.

3. Komparator nach einem der Ansprüche 1 oder 2, dadurch gekennzeichnet, daß der Komparator einen zweiten Schalter zur Unterbrechung der Stromversorgung der zweiten Stufe des ersten oder des dritten Komparators (i, k) während der Phase des auto-zéro der ersten Stufen enthält und daß der zweite Schalter zwischen der Betriebsspannung (VDD) und dem Gate des zweiten und des dritten Transistors (26, 30) liegt.

4. Komparator nach einem der vorangehenden Ansprüche, dadurch gekennzeichnet, daß die Transistoren und die Schalter durch MOS-Transistoren gebildet sind.

5. Analog/Digital-Konverter, dadurch gekennzeichnet, daß der Konverter eine oder mehrere Komparatoren mit Interpolation zu Mehrfachvergleichen nach einem der Ansprüche 1 bis 4 enthält.

6. Analog/Digital-Konverter nach Anspruch 5, dadurch gekennzeichnet, daß die Schalter des oder der Komparatoren mit Interpolation zu Mehrfachvergleichen gemäß dem folgenden Ablauf gesteuert werden:
- Schließen des zweiten Schalters (6) der ersten Stufe und des zweiten Schalters der zweiten Stufe, wobei der erste Schalter (27, 38) der zweiten Stufe geöffnet bleibt,
- schnelles Schließen des ersten Schalters (27, 38) der zweiten Stufe und gleichzeitiges Öffnen des zweiten Schalters der zweiten Stufe,
- Öffnen des zweiten Schalters (6) der ersten Stufe und des ersten Schalters (27, 38) der zweiten Stufe unmittelbar vor der Vergleichsphase.

## Claims

1. Multiple-comparison interpolated comparator, including:
- a first and a third auto-zero comparator (i,k) both comprising a first and a second stage, as well as, interposed between the first and the third comparator, a second comparator (j) including only a second stage connected to the two outputs of the two first stages of the adjacent comparators (i,k),
- the first stage of both of the first and third comparators (i,k) including a capacitor (4) intended to be charged by the voltages to be compared (Vrefi, Vrefk, Vin) respectively by two first switches (2, 3), and an inverter (5) whose input and output terminals are joined by a second switch (6) with a view to fulfilling the auto-zero function,
- the second stage of both of the first and third comparators (i,k) including a first transistor (21) whose gate is controlled by the output of the previous stage, the said first transistor being mounted as an inverter with a second transistor (26), whose gate and drain are joined by a first switch (27) with a view to fulfilling the auto-zero function, and a third transistor (30) which is used as a capacitor and whose gate is connected to the gate of the second transistor (26), and whose source and drain are connected to a supply voltage (Vdd),
- the second stage of the second comparator (j) including two first transistors (31,32) in parallel whose gates are controlled respectively by the outputs (20) of the first stages of the adjacent comparators (i,k), the two first transistors forming an inverter with two second transistors (34, 35) in parallel whose gates are connected in common and are connected through a first switch (38) to the drains of the two first transistors with a view to fulfilling the auto-zero function, the said second stage furthermore comprising two third transistors (36, 37) whose sources and drains are joined to the supply voltage (Vdd) and whose gates are connected to the gates of the second transistors (34,35).

2. Comparator according to Claim 1, characterized in that it includes a second switch for cutting the consumption of the second stage of the second comparator (j) during the auto-zero phase of the first stages, the said second switch being connected between the supply voltage (Vdd) and the gates of the second transistors and third transistors (34, 35, 36, 37).

3. Comparator according to one of Claims 1 and 2, characterized in that it includes a second switch for cutting the consumption of the second stage of the first or the third comparator (i,k) during the auto-zero phase of the first stages, the said second switch being connected between the supply voltage (Vdd) and the gate of the second and third transistors (26, 30).

4. Comparator according to one of the preceding claims, characterized in that the transistors and the switches are MOS transistors.

5. Analogue/digital converter, characterized in that it includes one or more multiple-comparison interpolated comparators according to any one of Claims 1 to 4.

6. Analogue/digital converter according to Claim 5, characterized in that the switches of the said multiple-comparison interpolated comparator or comparators are operated using the following sequence:
- closing the second switch (6) of the first stage and the second switch of the second stage, the first switch (27, 38) of the second stage being open,
- rapidly closing the first switch (27, 38) of the second stage and simultaneously opening the second switch of the second stage,
- opening the second switch (6) of the first stage and the first switch (27, 38) of the second stage just before the comparison phase.
